# EUROPEAN PATENT SPECIFICATION

(11) **EP 2 009 736 B1**
(45) Date of publication and mention of the grant of the patent: **13.01.2016**
(21) Application number: 07715145.4
(22) Date of filing: 02.03.2007
(51) Int. Cl.: H01Q 1/38, G06K 19/07, G06K 19/077, H01Q 1/22, H01Q 1/50, H01Q 9/16, H01Q 9/28

(54) **WIRELESS IC DEVICE**
DRAHTLOSE IC-VORRICHTUNG
COMPOSANT A CIRCUIT INTEGRE SANS FIL

(30) Priority: 14.04.2006 JP 2006112351
(43) Date of publication of application: 31.12.2008
(73) Proprietor: Murata Manufacturing Co. Ltd., Nagaokakyo-shi, Kyoto 617-8555 (JP)
(72) Inventor: KATO, Noboru, Nagaokakyo-shi, Kyoto 617-8555 (JP); ISHINO, Satoshi, Nagaokakyo-shi, Kyoto 617-8555 (JP)
(74) Representative: Zimmermann, Tankred Klaus
(86) International application number: PCT/JP2007/054051
(87) International publication number: WO 2007/119304

(56) References cited:
- EP-A1- 1 548 674
- EP-A2- 1 605 397
- DE-A1- 10 133 588
- DE-A1- 19 628 504
- JP-A- 2003 085 520
- JP-A- 2003 209 421
- JP-A- 2003 242 471
- JP-A- 2006 025 390
- US-A1- 2006 055 541
- US-B1- 6 181 287

## Description

### Technical Field

The present invention relates to wireless IC devices, and, in particular, to a wireless IC device for use in an RFID (Radio Frequency Identification) system.

### Background Art

In recent years, as an article management system, an RFID system has been developed in which communication is established in a noncontact manner between a reader/writer that generates an induction field and an IC tag (hereinafter referred to as a wireless IC device) which is affixed to an article and which stores predetermined information, whereby information is conveyed. As a wireless IC device for use in an RFID system, for example, the device as described in Non-Patent Document 1.

A wireless IC device of the above type is formed such that a wireless IC chip is mounted on a strap substrate and the strap substrate is further joined to an antenna substrate. The wireless IC chip and the strap substrate are directly, electrically joined to each other by an Au bump, and the strap substrate and the antenna substrate are directly, electrically joined to each other.

However, since, in the wireless IC device, a center frequency and impedance are set on an antenna side, in order for the device to match a plurality of frequencies and impedances, it is necessary to prepare antennas for the individual frequencies and impedances. Accordingly, the wireless IC device is not suitable for limited production of diversified products.

Also, since the strap substrate and the antenna substrate are directly, electrically connected to each other, a heating step is needed, and materials for use in the antenna substrate or the like are limited. In addition, when a junction position between the strap substrate and the antenna substrate shifts, a center frequency and impedance are affected. In particular, in frequency bands higher than the UHF band, a minute change is not permitted. Thus, high-precision management is required.
Patent document 1: EP 1 605 397 A2 (HITACHI LTD [JP]) 14 December 2005. The document shows a wireless IC device having a feeder circuit according to the prior-art.
Non-Patent Document 1: Musen IC Tagu Katsuyo-no Subete (All about Wireless IC Tags), Nikkei BP Mukku-sha, pp. 112-1-26

### Disclosure of Invention

### Problems to be Solved by the Invention

Accordingly, it is an object of the present invention to provide a wireless IC device in which a frequency characteristic and impedance can be determined without depending on an antenna and whose production is facilitated.

### Means for Solving the Problems

To achieve the object, the present invention provides a wireless IC device according to claim 1.

In the wireless IC device according to the present invention, the radiation plates have a function of radiating a transmitting signal supplied from the feeder circuit and a function of receiving and supplying a received signal to the feeder circuit. Transmission and reception to and from the wireless IC chip is performed by the feeder circuit. The frequency of the transmitting signal radiated from the radiation plates and the frequency of the received signal supplied to the wireless IC chip are substantially determined by a resonant frequency of the feeder circuit. In other words, a center frequency is determined by the feeder circuit, regardless of the shapes or the like of the radiation plates. By changing only the feeder circuit, many types of frequencies and impedances can be treated, and, for joining the feeder circuit and the radiation plates, high precision is not required. In addition, if the radiation plates are rounded, and are sandwiched between dielectrics, a frequency characteristic does not change. An attachment location of the wireless IC device can be freely selected, and a stable frequency characteristic is obtained.

In the wireless IC device according to the present invention, a cutout for adjusting the resonant frequency and the impedance is formed in an electrode pattern of the feeder circuit. By changing the depth and width of the cutout, the resonant frequency and the impedance can be easily adjusted. In addition, by forming the radiation plates with flexible metal films on the sheet, handling of the wireless IC device is facilitated.

Furthermore, the wireless IC chip and the feeder circuit may be provided on a first main face of the sheet, and the radiation plates may be provided on a second main face opposite to the first main face. The feeder circuit and the radiation plates may be capacitively coupled with each other through the sheet. A single sheet can form the wireless IC device, and the existence of a capacitor improves anti-surge functionality. A surge can be cut by a capacitor since it is a current having a low frequency up to 200 MHz, so that the wireless IC chip can be prevented from being broken due to a surge.

In addition, the wireless IC chip and the feeder circuit may be disposed on a first main face of a flexible first sheet, and the radiation plates may be disposed on a first main face of a flexible second sheet. The sheets may be bonded to each other so that the first main faces of the sheets oppose each other, and the feeder circuit and the radiation plates may be coupled with each other. In this case, the feeder circuit and the radiation plates may be directly, electrically coupled with each other or may be capacitively coupled through an adhesive layer. Since the wireless IC chip, the feeder circuit, and the radiation plates are coated with two sheets, these members are protected from the outside air such as moisture. In addition, regarding capacitive coupling, coupling does not need a heating step, and sheet materials can be widely selected other than heat resisting materials.

Furthermore, the wireless IC chip and the feeder circuit may be provided on a first main face of a flexible first sheet, and the radiation plates may be provided on a first main face of a flexible second sheet. The sheets may be bonded to each other so that the first main face of the first sheet and a second main face opposite to the first main face of the second sheet oppose each other, and the feeder circuit and the radiation plates may be capacitively coupled with each other by the second sheet. Also in this case, coupling does not need a heating step.

### Advantages

According to the present invention, a frequency characteristic and impedance are determined by a feeder circuit without depending on radiation plates for signal transmission and reception to and from the exterior. Thus, by changing the shape of an electrode pattern of the feeder circuit, various types of frequencies and impedances can be treated, and this is suitable for diversified production. In addition, for joining the feeder circuit and the radiation plates, high precision is not required. Thus, production is facilitated, and, in particular, this is advantageous in producing a wireless IC device used in frequencies higher than the UHF band.

### Brief Description of Drawings

Fig. 1 is an exploded perspective view showing a first embodiment of a wireless IC device according to the present invention, and part (A) shows a back face and part (B) shows a front face.
Fig. 2 is a sectional view showing the first embodiment.
Fig. 3 is an exploded perspective view showing first and second sheets included in second, third, and fourth embodiments of the wireless IC device according to the present invention.
Fig. 4 shows a second embodiment, and part (A) is a sectional view of a state before bonding, and part (B) is a sectional view of a state after bonding.
Fig. 5 shows a third embodiment, and part (A) is a sectional view of a state before bonding, and part (B) is a sectional view of a state after bonding.
Fig. 6 shows a fourth embodiment, and part (A) is a sectional view of a state before bonding, and part (B) is a sectional view of a state after bonding.

### Best Modes for Carrying Out the Invention

Embodiments of a wireless IC device according to the present invention are described below with reference to the accompanying drawings. Common components and portions of the embodiments described below are denoted by identical reference numerals, and repeated descriptions thereof are omitted.

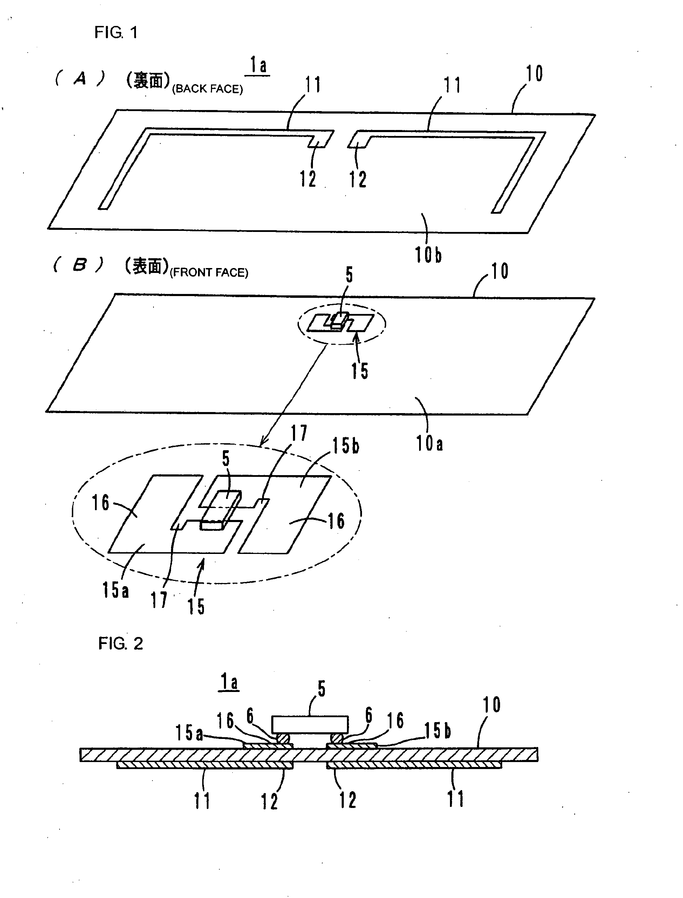

### (First Embodiment, See Figs. 1 and 2)

A wireless IC device 1a that is a first embodiment is formed such that, as shown in Fig. 1(A), radiation plates 11 are formed with a metal thin film such as a flexible aluminum foil or metal deposition film on a second main face (back face) 10b of a flexible dielectric sheet 10 (for example, a resin film such as PET, or paper), and, as shown in Fig. 1(B), a feeder circuit 15 is formed on a first main face (front face) 10a. A wireless IC chip 5 is mounted on the feeder circuit 15. Fig. 1(B) shows, in an enlarged manner, the feeder circuit 15 on which the wireless IC chip 5 is mounted.

The wireless IC chip 5 is a known device which includes a clock circuit, a logic circuit, and a memory circuit, and which stores necessary information. The wireless IC chip 5 can transmit and receive predetermined high frequency signals. Terminal electrodes of the wireless IC chip 5 are electrically connected to electrode patterns 15a and 15b of the feeder circuit 15 via Au bumps 6 (see Fig. 2), with the electrodes stepping over the electrodes patterns 15a and 15b. The electrical connection may be connection by soldering or a conductive adhesive other than the Au bumps 6.

Similarly to the radiation plates 11, the feeder circuit 15 is also formed by a metal thin film such as flexible aluminum foil or metal deposition film. Ends 16 of the electrode patterns 15a and 15b oppose ends 12 of the radiation plates 11, with the sheet 10 provided therebetween, whereby capacitive coupling is established.

The wireless IC device 1a uses the radiation plates 11 to receive a high frequency signal (for example, the UHF frequency band) radiated from a reader/writer (not shown), Causes the feeder circuit 15 capacitively coupled with the radiation plates 11 to resonate, and supplies energy to the wireless IC chip 5. In addition, the wireless IC device 1a extracts predetermined energy from the received signal, and in the feeder circuit 15, matches the information stored in the wireless IC chip 5 with a predetermined frequency by using the energy as a drive source. After that, a transmitting signal is conveyed to the radiation plates 11 through the capacitive coupling, and the signal is transmitted and transferred from the radiation plates 11 to the reader/writer.

In the wireless IC device 1a according to the first embodiment, the feeder circuit 15 has a predetermined resonant frequency and a predetermined impedance. The resonant frequency and the impedance are adjusted by changing the depths and/or widths of cutouts 17 formed in the electrode patterns 15a and 15b. In other words, by enlarging the cutouts 17, the impedance is increased. In addition, by increasing the depths of the cutouts 17, an inductance increases and a center frequency (fo) decreases. Such adjustment is performed by trimming the electrode patterns 15a and 15b with a laser or the like. For example, the resonant frequency can be fine adjusted to 868 MHz, 915 MHz, 953 MHz, etc.

As described above, in the wireless IC device 1a, the frequency of the transmitting signal radiated from the radiation plates 11, and the frequency of the received signal supplied to the wireless IC chip 5 are substantially determined by the resonant frequency of the feeder circuit 15. In other words, the center frequency is determined by the feeder circuit 15 regardless of the shapes or the like of the radiation plates 11. By changing the shapes of the electrode patterns 15a and 15b of the feeder circuit 15, many types of frequencies and impedances can be treated. For joining the radiation plates 11 and the feeder circuit 15, high precision is not required, and it is not necessary to change the shapes of the radiation plates 11. Thus, a signal radiation characteristic does not change. If the radiation plates 11 are rounded or sandwiched between dielectrics, a frequency characteristic does not change. Thus, an attachment location of the wireless IC device 1a can be freely selected, and a stable frequency characteristic is obtained.

Furthermore, capacitive coupling between the radiation plates 11 and the feeder circuit 15 improves anti-surge functionality. Since a surge is a current having a low frequency up to 200 MHz, the surge can be cut by a capacitor, and the wireless IC chip 5 can be prevented from being broken due to a surge. In addition, since the radiation plates 11 and the feeder circuit 15 are capacitively coupled, the coupling does not need a heating step. Accordingly, regarding a material for the sheet 10, various types of materials can be selected other than a heat resistance material.

In addition, an electrical length of each of the radiation plates 11 is 1/4 of resonant frequency λ, and the radiation plates 11 have a total of 1/2 of resonant frequency λ. The electrical length of the radiation plates 11 is not necessary to be an integer multiple of λ/2. In other words, in the present invention, the frequency of the signal radiated from the radiation plates 11 is substantially determined by the resonant frequency of the feeder circuit 15. Thus, a frequency characteristic is not dependent on the electrical length of the radiation plates 11. It is preferable that the electrical length of the radiation plates 11 be an integer multiple of λ/2 since a gain is maximum. This point can also be applied to second, third, and fourth embodiments, which are described below.

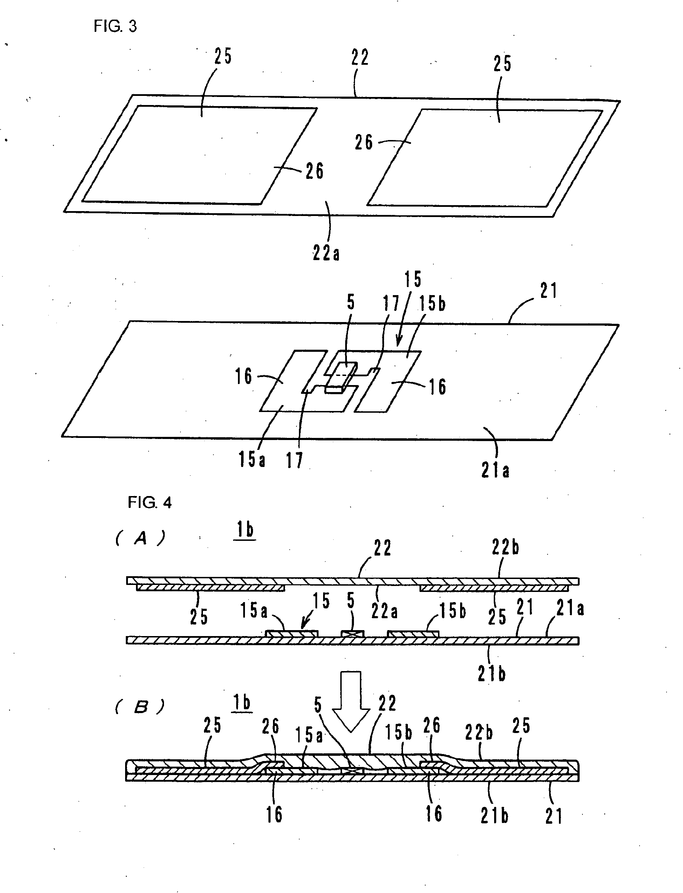

### (Second, Third, and Fourth Embodiments, See Figs. 3 to 6)

As shown in Fig. 3, each of second, third, and fourth embodiments, which are described below, is formed by bonding two sheets 21 and 22 made of a flexible dielectric or insulator. On a first main face 21a of the first sheet 21, a feeder circuit 15 is formed with a metal thin film such as flexible aluminum foil or metal deposition film. A wireless IC chip 5 is mounted on the feeder circuit 15. On a first main face 22a of the second sheet 22, radiation plates having large areas are formed with a metal thin film such as flexible aluminum foil or metal deposition film.

The feeder circuit 15 is identical in configuration to the feeder circuit 15 shown in the first embodiment. The wireless IC chip 5 is electrically connected to two electrode patterns 15a and 15b, with the wireless IC chip 5 stepping over the electrode patterns 15a and 15b. In addition, the feeder circuit 15 has a predetermined resonant frequency and a predetermined impedance. Similarly to the above, these are adjusted by changing the depths and/or widths of cutouts 17.

### (Second Embodiment, See Fig. 4)

As shown in Fig. 4, in a wireless IC device 1b that is a second embodiment, the first sheet 21 and the second sheet 22 are bonded to each other by heat bonding so that a first main face 21a and a first main face 22a oppose each other. Ends 16 of the feeder circuit 15 and ends 26 of the radiation plates 25 are directly, electrically coupled.

The wireless IC device 1b uses radiation plates 25 to receive a high frequency signal (for example, the UHF frequency band) radiated from a reader/writer (not shown), causes the feeder circuit 15, which is directly and electrically coupled with the radiation plates 25, to resonate, and supplies energy to the wireless IC chip 5. The wireless IC device 1b extracts predetermined energy from the received signal, and in the feeder circuit 15, matches information stored in the wireless IC chip 5 with a predetermined frequency by using the energy as a drive source. After that, a transmitting signal is conveyed to the radiation plates 25 through the direct, electrical coupling, and the signal is transmitted and transferred from the radiation plates 25 to the reader/writer.

Therefore, an operation and advantages of the wireless IC device 1b that is the second embodiment are similar to those of the wireless IC device 1a that is the first embodiment. In addition, the wireless IC chip 5, the feeder circuit 15, and the radiation plates 25 are coated with two sheets 21 and 22. Thus, these members are protected from the outside air such as moisture. In other words, rust or the like does hot occur in the feeder circuit 15 and the radiation plates 25, and it is ensured that disengagement of the wireless IC chip 5 is prevented. In addition, joined portions between the ends 16 of the feeder circuit 15 and the ends 26 of the radiation plates 25 have no possibility of shifting if they are not particularly fixed.

Furthermore, on second main faces 21b and 22b opposite to the first main faces 21a and 22a of the sheets 21 and 22, necessary information (for example, advertisement information or a bar code) can be printed.

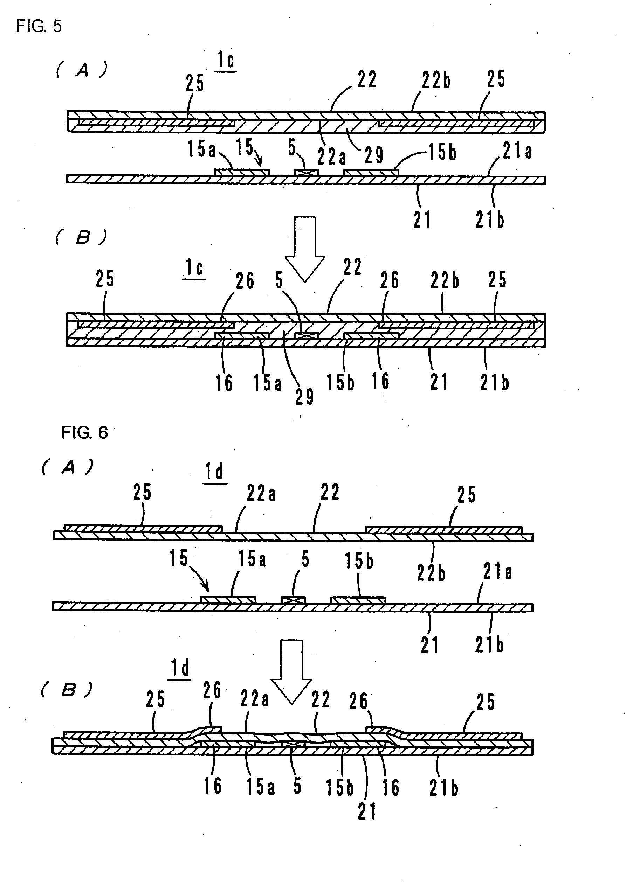

### (Third Embodiment, See Fig. 5)

As shown in Fig. 5, in a wireless IC device 1c that is a third embodiment, the first sheet 21 and the second sheet 22 are bonded to each other through an adhesive layer 29 so that a first main face 21a and a first main face 22a oppose each other. Ends 16 of the feeder circuit 15 and ends 26 of radiation plates 25 are capacitively coupled through an adhesive layer 29 so as to oppose each other.

The wireless IC device 1c uses radiation plates 25 to receive a high frequency signal (for example, the UHF frequency band) radiated from a reader/writer (not shown), causes the feeder circuit 15 capacitively coupled with the radiation plates 25 to resonate, and supplies energy to the wireless IC chip 5. In addition, the wireless IC device 1c extracts predetermined energy from the received signal, and in the feeder circuit 15, matches information stored in the wireless IC chip 5 with a predetermined frequency by using the energy as a drive source. After that, a transmitting signal is conveyed to the radiation plates 25 through the capacitive coupling, and the signal is transmitted and transferred from the radiation plates 25 to the reader/writer.

Therefore, an operation and advantages of the wireless IC device 1c that is the third embodiment are similar to those of the wireless IC device 1a that is the first embodiment. In addition, an advantage of a construction in which the wireless IC chip 5, the feeder circuit 15, and the radiation plates 25 are coated with two sheets 21 and 22 is similar to that of the wireless IC device 1b that is the second embodiment.

### (Fourth Embodiment, See Fig. 6)

As shown in Fig. 6, in a wireless IC device 1d that is a fourth embodiment, a first sheet 21 and a second sheet 22 are bonded to each other by heat bonding so that a first main face 21a and a second main face 22b oppose each other. Ends 16 of the feeder circuit 15 and ends 26 of radiation plates 25 are capacitively coupled, with the second sheet 22 provided therebetween.

The wireless IC device 1d uses the radiation plates 25 to receive a high frequency signal (for example, the UHF frequency band) radiated from a reader/writer (not shown), causes the feeder circuit 15 capacitively coupled with the radiation plates 25 to resonate, and supplies energy to the wireless IC chip 5. In addition, the wireless IC device 1d extracts predetermined energy from the received signal, and in the feeder circuit 15, matches information stored in the wireless IC chip 5 with a predetermined frequency by using the energy as a drive source. After that, a transmitting signal is conveyed to the radiation plates 25 through the capacitive coupling, and the signal is transmitted and transferred from the radiation plates 25 to the reader/writer.

Therefore, an operation and advantages of the wireless IC device 1d that is the fourth embodiment are similar to those of the wireless IC device 1a that is the first embodiment. In addition, an advantage of a construction in which the wireless IC chip 5, the feeder circuit 15, and the radiation plates 25 are coated with two sheets 21 and 22 is similar to that of the wireless IC device 1b that is the second embodiment.

### (Other Embodiments)

The wireless IC device according to the present invention is not limited to the embodiments, and can be variously modified within the gist of the present invention.

For example, a detailed construction of the wireless IC chip 5 is optional, and specific shapes of the feeder circuit 15, and the radiation plates 11 and 25 are optional.

### Industrial Applicability

As described above, the present invention is useful in a wireless IC device for use in an RFID system. In particular, it is superior in determining a frequency characteristic and impedance without depending on an antenna and in ease of production.

## Claims

1. A wireless IC device (1a; 1b; 1c; 1d) comprising:
a flexible sheet (10; 21) provided with a wireless IC chip (5) and radiation plates (11; 25); and
a feeder circuit (15),
wherein the wireless IC chip (5) is connected to the feeder circuit (15), wherein the feeder circuit (15) is formed on the sheet (10; 21) and has a predetermined resonant frequency and a predetermined impedance,
wherein the feeder circuit (15) and the radiation plates (11; 25) are coupled with each other, wherein a transmitting signal is radiated from the radiation plates (11; 25) and a received signal is supplied to the wireless IC chip (5) by the feeder circuit (15), and
wherein the feeder circuit (15) comprises a first electrode pattern (15a) and a second electrode pattern (15b),
wherein one end of the first electrode pattern (15a) is formed L-shaped by cranking the first electrode pattern (15a) and one end of the second electrode pattern (15b) is formed L-shaped by cranking the second electrode pattern (15b), wherein the one end of the first electrode pattern (15a) is opposed to the one end of the second electrode pattern (15b),
wherein the wireless IC chip (5) is electrically connected with the electrode patterns (15a, 15b) by stepping over both, the one end of the first electrode pattern (15a) and the one end of the second electrode pattern (15b), and
wherein a cutout (17) for adjusting the resonant frequency and the impedance is formed in the first and second electrode patterns (15a, 15b) of the feeder circuit (15), wherein the cutout (17) is formed at the inner corner of the L-shaped electrode patterns (15a, 15b).

2. The wireless IC device (1a; 1b; 1c; 1d) according to Claim 1, wherein the radiation plates (11; 25) are formed on the sheet (10; 21) by flexible metal films.

3. The wireless IC device (1a) according to Claim 1 or 2,
wherein the wireless IC chip (5) and the feeder circuit (15) are provided on a first main face (10a) of the sheet (10), and the radiation plates (11) are provided on a second main face (10b) opposite to the first main face (10a), and
wherein the feeder circuit (15) and the radiation plates (11) are capacitively coupled with each other through the sheet (10).

4. The wireless IC device (1b; 1c) according to Claim 1 or 2,
wherein the wireless IC chip (5) and the feeder circuit (15) are provided on a first main face (21 a) of a flexible first sheet (21), and the radiation plates (25) are provided on a first main face (22a) of a flexible second sheet (22), and
wherein the first and second sheets (21, 22) are bonded to each other so that the first main face (21 a) of the first sheet (21) and the first main face (22a) of the second sheet (22) oppose each other, and the feeder circuit (15) and the radiation plates (25) are coupled with each other.

5. The wireless IC device (1b) according to Claim 4, wherein the feeder circuit (15) and the radiation plates (25) are directly, electrically coupled with each other.

6. The wireless IC device (1c) according to Claim 4, further comprising an adhesive layer (29), wherein the feeder circuit (15) and the radiation plates (25) are capacitively coupled with each other through the adhesive layer (29).

7. The wireless IC device (1d) according to Claim 1 or 2,
wherein the wireless IC chip (5) and the feeder circuit (15) are provided on a first main face (21 a) of a flexible first sheet (21), and the radiation plates (25) are provided on a first main face (22a) of a flexible second sheet (22), and
wherein the first and second sheets (21, 22) are bonded to each other so that the first main face (21 a) of the first sheet (21) and a second main face (22b) opposite to the first main face (22a) of the second sheet (22) oppose each other, and the feeder circuit (15) and the radiation plates (25) are capacitively coupled with each other through the second sheet (22).

## Patentansprüche

1. Ein drahtloses IC-Bauelement (1a; 1b; 1c; 1d), das folgende Merkmale aufweist:
eine flexible Lage (10; 21), die mit einem drahtlosen IC-Chip (5) und Strahlungsplatten (11; 25) versehen ist; und
eine Zuführerschaltung (15),
wobei der drahtlose IC-Chip (5) mit der Zuführerschaltung (15) verbunden ist, wobei die Zuführerschaltung (15) auf der Lage (10; 21) gebildet ist und eine vorbestimmte Resonanzfrequenz und eine vorbestimmte Impedanz aufweist,
wobei die Zuführerschaltung (15) und die Strahlungsplatten (11; 25) miteinander gekoppelt sind, wobei ein Sendesignal von den Strahlungsplatten (11; 25) abgestrahlt wird und ein empfangenes Signal durch die Zuführerschaltung (15) an den drahtlosen IC-Chip (5) geliefert wird, und
wobei die Zuführerschaltung (15) eine erste Elektrodenstruktur (15a) und eine zweite Elektrodenstruktur (15b) aufweist,
wobei ein Ende der ersten Elektrodenstruktur (15a) durch Krümmen der ersten Elektrodenstruktur (15a) L-förmig gebildet ist und ein Ende der zweiten Elektrodenstruktur (15b) durch Krümmen der zweiten Elektrodenstruktur (15b) L-förmig gebildet ist, wobei das eine Ende der Elektrodenstruktur (15a) dem einen Ende der zweiten Elektrodenstruktur (15b) gegenüberliegt,
wobei der drahtlose IC-Chip (5) durch Überschreiten beider, des einen Endes der ersten Elektrodenstruktur (15a) und des einen Endes der zweiten Elektrodenstruktur (15b), mit den Elektrodenstrukturen (15a, 15b) elektrisch verbunden ist und
wobei ein Ausschnitt (17) zum Anpassen der Resonanzfrequenz und der Impedanz in der ersten und zweiten Elektrodenstruktur (15a, 15b) der Zuführerschaltung (15) gebildet ist, wobei der Ausschnitt (17) an der inneren Ecke der L-förmigen Elektrodenstrukturen (15a, 15b) gebildet ist.

2. Das drahtlose IC-Bauelement (1a; 1 b; 1 c; 1 d) gemäß Anspruch 1, bei dem die Strahlungsplatten (11, 25) auf der Lage (10; 21) durch flexible Metallfilme gebildet sind.

3. Das drahtlose IC-Bauelement (1a) gemäß Anspruch 1 oder 2,
wobei der drahtlose IC-Chip (5) und die Zuführerschaltung (15) auf einer ersten Hauptfläche (10a) der Lage (10) bereitgestellt sind und die Strahlungsplatten (11) auf einer zweiten Hauptfläche (10b) gegenüber der ersten Hauptfläche (10a) bereitgestellt sind und
wobei die Zuführerschaltung (15) und die Strahlungsplatten (11) durch die Lage (10) miteinander kapazitiv gekoppelt sind.

4. Das drahtlose IC-Bauelement (1b; 1c) gemäß Anspruch 1 oder 2,
wobei der drahtlose IC-Chip (5) und die Zuführerschaltung (15) auf einer ersten Hauptfläche (21 a) einer flexiblen ersten Lage (21) bereitgestellt sind und die Strahlungsplatten (25) auf einer ersten Hauptfläche (22a) einer flexiblen zweiten Lage (22) bereitgestellt sind und
wobei die erste und die zweite Lage (21, 22) aneinander gebunden sind, so dass die erste Hauptfläche (21a) der ersten Lage (21) und die erste Hauptfläche (22a) der zweiten Lage (22) einander gegenüberliegen und die Zuführerschaltung(15) und die Strahlungsplatten (25) miteinander gekoppelt sind.

5. Das drahtlose IC-Bauelement (1b) gemäß Anspruch 4, bei dem die Zuführerschaltung (15) und die Strahlungsplatten (25) direkt miteinander elektrisch gekoppelt sind.

6. Das drahtlose IC-Bauelement (1c) gemäß Anspruch 4, das ferner eine Haftschicht (29) aufweist, wobei die Zuführerschaltung (15) und die Strahlungsplatten (25) durch die Haftschicht (29) miteinander kapazitiv gekoppelt sind.

7. Das drahtlose IC-Bauelement (1d) gemäß Anspruch 1 oder 2,
wobei der drahtlose IC-Chip (5) und die Zuführerschaltung (15) auf einer ersten Hauptfläche (21 a) einer flexiblen ersten Lage (21) bereitgestellt sind und die Strahlungsplatten (25) auf einer ersten Hauptfläche (22a) einer flexiblen zweiten Lage (22) bereitgestellt sind und
wobei die erste und die zweite Lage (21, 22) aneinander gebunden sind, so dass die erste Hauptfläche (21a) der ersten Lage (21) und eine zweite Hauptfläche (22b) gegenüber der ersten Hauptlage (22a) der zweiten Lage (22) einander gegenüberliegen und die Zuführerschaltung (15) und die Strahlungsplatten (25) durch die zweite Lage (22) miteinander kapazitiv gekoppelt sind.

## Revendications

1. Dispositif CI sans fil (1a ; 1b ; 1c ; 1d) comportant :
une feuille flexible (10 ; 21) équipée d'une puce CI sans fil (5) et de plaques de rayonnement (11, 25) ; et
un circuit d'alimentation (15),
dans lequel la puce CI sans fil (5) est reliée au circuit d'alimentation (15), dans lequel le circuit d'alimentation (15) est formé sur la feuille (10 ; 21) et possède une fréquence résonnante prédéterminée et une impédance prédéterminée,
dans lequel le circuit d'alimentation (15) et les plaques de rayonnement (11 ; 25) sont couplés les uns aux autres, dans lequel un signal de transmission est rayonné depuis les plaques de rayonnement (11 ; 25) et un signal reçu est délivré à la puce CI sans fil (5) par le circuit d'alimentation (15), et
dans lequel le circuit d'alimentation (15) comporte un premier motif d'électrode (15a) et un second motif d'électrode (15b),
dans lequel une extrémité du premier motif d'électrode (15a) est en forme de L en tournant le premier motif d'électrode (15a) et une extrémité du second motif d'électrode (15b) est en forme de L en tournant le second motif d'électrode (15b), dans lequel la première extrémité du premier motif d'électrode (15a) est opposée à la première extrémité du second motif d'électrode (15b),
dans lequel la puce CI sans fil (5) est reliée électriquement aux motifs d'électrode (15a, 15b) en passant au-dessus des deux, la première extrémité du premier motif d'électrode (15a) et la première extrémité du second motif d'électrode (15b), et
dans lequel une découpe (17) pour régler la fréquence résonnante et l'impédance est formée dans les premier et second motifs d'électrode (15a, 15b) du circuit d'alimentation (15), dans lequel la découpe (17) est formée dans le coin intérieur des motifs d'électrode en forme de L (15a, 15b).

2. Dispositif CI sans fil (1a ; 1b ; 1c ; 1d) selon la revendication 1, dans lequel les plaques de rayonnement (11 ; 25) sont formées sur la feuille (10 ; 21) par des films métalliques flexibles.

3. Dispositif CI sans fil (1a) selon la revendication 1 ou 2,
dans lequel la puce CI sans fil (5) et le circuit d'alimentation (15) sont prévus sur une première surface principale (10a) de la feuille (10), les plaques de rayonnement (11) sont prévues sur une seconde surface principale (10b) opposée à la première surface principale (10a), et
dans lequel le circuit d'alimentation (15) et les plaques de rayonnement (11) sont couplés de manière capacitive les uns aux autres par l'intermédiaire de la feuille (10).

4. Dispositif CI sans fil (1b ; 1c) selon la revendication 1 ou 2,
dans lequel la puce CI sans fil (5) et le circuit d'alimentation (15) sont prévus sur une première surface principale (21a) de la première feuille flexible (21), et les plaques de rayonnement (25) sont prévues sur une première surface principale (22a) d'une seconde feuille flexible (22), et
dans lequel les première et seconde feuilles (21, 22) sont collées l'une à l'autre de manière que la première surface principale (21a) et la première surface principale (22a) de la seconde feuille (22) sont opposées l'une à l'autre, et le circuit d'alimentation (15) et les plaques de rayonnement (25) sont couplés les uns aux autres.

5. Dispositif CI sans fil (1b) selon la revendication 4, dans lequel le circuit d'alimentation (15) et les plaques de rayonnement (25) sont directement couplés électriquement les uns aux autres.

6. Dispositif CI sans fil (1c) selon la revendication 4, comportant en outre une couche adhésive (29), dans lequel le circuit d'alimentation (15) et les plaques de rayonnement (25) sont couplés de manière capacitive les uns aux autres par l'intermédiaire de la couche adhésive (29).

7. Dispositif CI sans fil (1d) selon la revendication 1 ou 2,
dans lequel la puce CI sans fil (5) et le circuit d'alimentation (15) sont prévus sur une première surface principale (21a) d'une première feuille flexible (21), et les plaques de rayonnement (25) sont prévues sur une première surface principale (22a) d'une seconde feuille flexible (22), et
dans lequel les première et seconde feuilles (21, 22) sont collées l'une à l'autre de manière que la première surface principale (21a) de la première feuille (21) et une seconde surface principale (22b) opposée à la première surface principale (22a) de la seconde feuille (22) sont opposées l'une à l'autre, et le circuit d'alimentation (15) et les plaques de rayonnement (25) sont couplés de manière capacitive l'une à l'autre par l'intermédiaire de la seconde feuille (22).
